# FASCICULE DE BREVET EUROPEEN

(11) **EP 0 817 277 B1**
(45) Date de publication et mention de la délivrance du brevet: **04.09.2002**
(21) Numéro de dépôt: 97410066.1
(22) Date de dépôt: 25.06.1997
(51) Int. Cl.: H01L 29/747, H01L 29/74

(54) **Réseau de triacs à gâchettes référencées par rapport à une électrode commune de face opposée**
TRIAC-Anordnung, deren Gatterreferenzspannung an gemeinsame Elektrode auf Rückseite gelegt wird
TRIAC array with gate reference potential being applied to common backside electrode

(30) Priorité: 28.06.1996 FR 9608300
(43) Date de publication de la demande: 07.01.1998
(73) Titulaire: STMicroelectronics S.A., 92120 Montrouge (FR)
(72) Inventeur: Pezzani, Robert, 37210 Parcay-Meslay (FR)
(74) Mandataire: de Beaumont, Michel

(56) Documents cités:
- EP-A- 0 709 891
- FR-A- 2 535 529
- US-A- 3 409 810
- US-A- 5 345 094
- RCA TECHNICAL NOTES, vol. 2180, no. 1343, Mars 1984, PRINCETON US, pages 1-6, XP002027539 J. M. S. NEILSON ET R. A. DUCLOS: "Avalanche Diode Structure"

## Description

La présente invention concerne les commutateurs bidirectionnels, couramment appelés triacs, de moyenne puissance.

De façon générale, une première face ou face arrière d'un triac est destinée à être reliée à un radiateur et porte une métallisation uniforme constituant une première borne principale du triac. La face opposée ou face avant porte une deuxième métallisation de grande dimension constituant la deuxième borne principale du triac et une ou plusieurs métallisations secondaires dont l'une au moins constitue une borne de commande ou gâchette.

De façon générale, la borne de commande est référencée par rapport à la borne principale située sur la même face avant. Ceci peut présenter un inconvénient, notamment quand on veut réaliser de façon monolithique ou non plusieurs triacs ayant une électrode principale commune, généralement reliée à la masse et montée sur un radiateur. Les gâchettes des divers triacs sont alors référencées à des secondes bornes principales qui se trouvent à des potentiels élevés et éventuellement différents. Pour commander les divers triacs sélectivement, on doit prévoir un circuit de commande dont les tensions de référence sont des tensions hautes et éventuellement distinctes. Ainsi, on se heurte à des problèmes de réalisation de circuits de commande relativement complexes, ou bien on doit utiliser des triacs discrets dont les faces arrière montées sur radiateur pour le refroidissement sont à des potentiels différents (ce qui entraîne qu'il faut prévoir un radiateur par triac ou des montages isolés).

Cette situation se rencontre dans de très nombreux dispositifs. Par exemple, dans une machine à laver, plusieurs triacs sont utilisés pour les commandes des pompes, des électrovannes de remplissage, des divers distributeurs... Ces triacs de moyenne puissance sont commandés par le même programmateur et leurs bornes principales auxquelles sont référencées les gâchettes sont interconnectées. Etant donné que ces bornes principales sont disposées du côté de la gâchette, il n'est pas possible de réaliser une structure monolithique et de braser la métallisation correspondant à la borne commune sur un même radiateur car alors on court-circuiterait les métallisations de gâchette disposées sur la même face. De telles dispositions se retrouvent dans de nombreux autres systèmes, par exemple, dans des commandes de volets roulants dans lesquels les moteurs comprennent un enroulement pour la fermeture du volet et un autre pour l'ouverture.

Ainsi, un objet de la présente invention est de prévoir une structure de triac telle que plusieurs triacs puissent être assemblés en réseau avec une électrode commune, cette électrode commune constituant la référence par rapport à laquelle est choisie la tension appliquée à l'électrode de commande. Un autre type de composant semiconducteur est décrit dans FR2535529

Un autre objet de la présente invention est de prévoir une telle structure destinée à des courants alternatifs dans laquelle la tension de commande a toujours la même polarité par rapport à la borne principale commune de référence quelle que soit la polarité sur l'autre borne principale (alternance positive ou négative de la tension du secteur).

Un autre objet de la présente invention est de prévoir une structure monolithique incorporant un réseau de triacs.

Un autre objet de la présente invention est de prévoir une telle structure monolithique simple à fabriquer par les procédés couramment utilisés actuellement pour la fabrication des thyristors et triacs.

Pour atteindre ces objets, ainsi que d'autres, la présente invention prévoit un réseau de triacs dans lequel chaque triac comprend un substrat semiconducteur du premier type de conductivité ayant une face avant et une face arrière, une couche du deuxième type de conductivité du côté de la face arrière, une diffusion profonde du deuxième type de conductivité reliant ladite couche à la face avant, un premier caisson du deuxième type de conductivité contenant une première région du premier type de conductivité du côté de la face avant, un deuxième caisson du deuxième type de conductivité du côté de la face avant, une deuxième région du premier type de conductivité du côté de la face arrière sensiblement en regard du deuxième caisson, et un troisième caisson du deuxième type de conductivité contenant une troisième région du premier type de conductivité du côté de la face avant. Une première métallisation du côté de la face arrière correspond à une première électrode principale, une deuxième métallisation du côté de la face avant recouvre la surface supérieure de la première région et du deuxième caisson et correspond à une deuxième électrode principale, une troisième métallisation recouvre l'un du troisième caisson et de la troisième région et est connectée à une borne de gâchette, et une quatrième métallisation relie l'autre du troisième caisson et de la troisième région à la surface supérieure de ladite diffusion profonde.

Selon un mode de réalisation de la présente invention, tous les triacs sont formés dans un même substrat semiconducteur et la première métallisation est une métallisation commune recouvrant la face arrière.

Selon un mode de réalisation de la présente invention, la diffusion profonde s'étend à la périphérie de chaque structure de triac.

Selon un mode de réalisation de la présente invention, le premier type de conductivité est le type N.

Selon un mode de réalisation de la présente invention, la borne de commande est reliée à la troisième région, et le réseau comprend en outre des moyens pour appliquer à cette borne de commande une tension positive par rapport au potentiel de la première électrode principale.

Selon un mode de réalisation de la présente invention, la borne de commande est reliée au troisième caisson, et le réseau comprend en outre des moyens pour appliquer à cette borne de commande une tension négative par rapport au potentiel de la première électrode principale.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1A représente une vue en coupe schématique d'un premier mode de réalisation d'une structure de triac selon la présente invention ;
la figure 1B représente un schéma équivalent du premier mode de réalisation quand la borne principale de face avant est à un potentiel inférieur à la borne principale de face arrière ;
la figure 1C représente un schéma équivalent du premier mode de réalisation quand la borne principale de face avant est à un potentiel supérieur à la borne principale de face arrière ;
la figure 2A représente une vue en coupe schématique d'un deuxième mode de réalisation d'une structure de triac selon la présente invention ;
la figure 2B représente un schéma équivalent du deuxième mode de réalisation quand la borne principale de face avant est à un potentiel inférieur à la borne principale de face arrière ;
la figure 2C représente un schéma équivalent du deuxième mode de réalisation quand la borne principale de face avant est à un potentiel supérieur à la borne principale de face arrière ;
la figure 3A est une vue de dessus d'une structure de réseau de triacs selon la présente invention avant réalisation de métallisations ; et
la figure 3B est une vue de dessus d'une structure de réseau de triacs selon la présente invention après réalisation de métallisations.

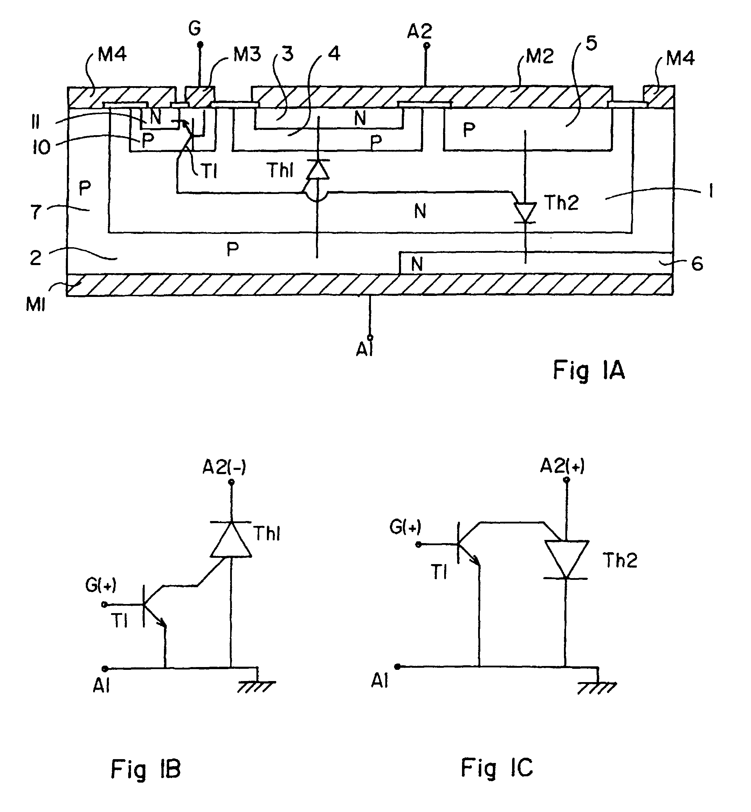

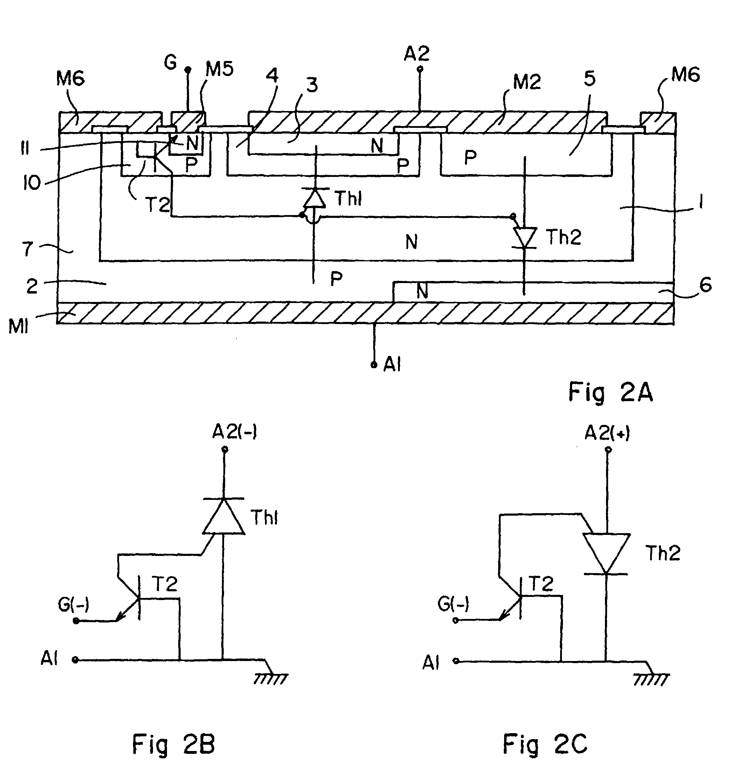

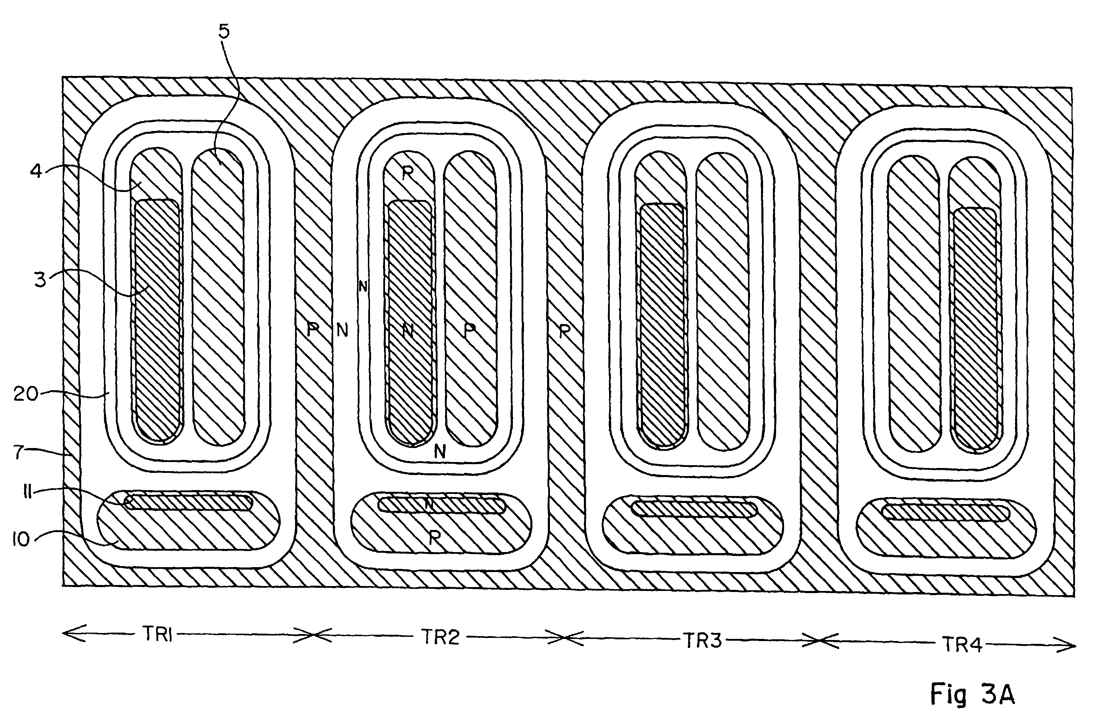

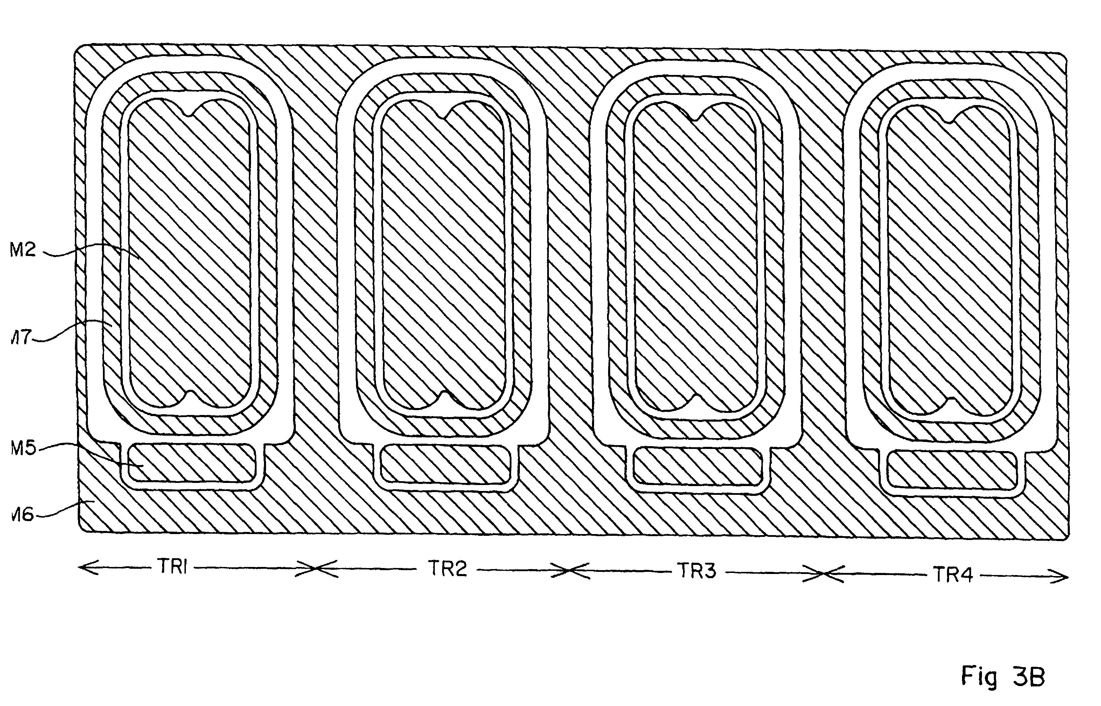

Comme cela est classique dans le domaine de la représentation des composants semiconducteurs, les vues en coupe des figures 1A et 2A sont extrêmement schématiques et ne sont pas à l'échelle. Pour un exemple de réalisation pratique, on pourra se référer aux vues de dessus des figures 3A et 3B.

La structure de la figure 1A est formée à partir d'un substrat semiconducteur 1 de type N faiblement dopé. Ce triac comprend de façon classique deux thyristors verticaux en antiparallèle Th1 et Th2. L'anode du thyristor Th1 correspond à une couche 2 de type P formée du côté de la face arrière du substrat. Sa cathode correspond à une région 3 du deuxième type de conductivité formée du côté de la face avant dans un caisson 4 de type P. L'anode du thyristor Th2 correspond à un caisson 5 de type P formé du côté de la face avant et sa cathode correspond à une région 6 de type N formée du côté de la face arrière dans la couche 2. Ce triac est du type dit à caisson, c'est-à-dire que sa périphérie est constituée d'une région 7 de type P fortement dopée s'étendant depuis la face avant jusqu'à la couche 2 de type P. De façon classique, la région 7 est obtenue par diffusion profonde à partir des deux faces du substrat. La face arrière est revêtue d'une métallisation M1 correspondant à une première borne principale A1 du triac et les faces supérieures des régions 3 et 5 sont revêtues d'une deuxième métallisation M2 correspondant à la deuxième borne principale A2 du triac.

Jusque là, on a décrit les éléments principaux d'un triac qui sont relativement classiques. La présente invention se distingue de l'art antérieur par la structure de déclenchement de ce triac. Celle-ci comprend un caisson 10 de type P formé du côté de la face avant ou supérieure dans lequel est formée une région 11 de type N.

Dans le mode de réalisation de la figure 1A, la surface du caisson 10 est solidaire d'une métallisation M3 reliée à une borne de gâchette G du triac et la surface de la région 11 est reliée par une métallisation M4 à la surface supérieure de la diffusion profonde périphérique 7.

On a également représenté sur la figure 1A les symboles de divers composants résultant de la structure représentée. Ainsi, on a représenté les thyristors Th1 et Th2 susmentionnés et un transistor T1 dont la base correspond à la région 10 et à la métallisation de gâchette G, dont l'émetteur correspond à la région 11 et à la métallisation M4 (c'est-à-dire que cet émetteur est relié par le caisson 7 à la première électrode principale A1 de face arrière ou inférieure du triac), et dont le collecteur correspond au substrat 1, c'est-à-dire aux régions de gâchette d'anode des thyristors Th1 et Th2.

Le fonctionnement de ce triac est le suivant.

Quand la borne A2 est négative par rapport à la borne A1, c'est le thyristor Th1 qui est susceptible d'être passant. Le schéma équivalent est alors celui de la figure 1B. Si l'on applique à la borne G une tension positive par rapport à l'électrode de face arrière A1, par exemple une tension de l'ordre de 6 volts, un courant circule entre les bornes G et A1 en passant par la jonction base-émetteur du transistor T1. Ce courant base-émetteur entraîne le passage d'un courant collecteur-émetteur dans le transistor T1 et donc le passage d'un courant entre l'anode et la gâchette d'anode du thyristor Th1 qui est alors mise à l'état conducteur. Une autre explication de la mise en conduction du thyristor Th1 est que la mise à l'état passant de la jonction base-émetteur du transistor T1 entraîne la génération de charges au voisinage de la jonction entre le substrat 1 et la région 4, c'est-à-dire une mise en conduction du thyristor Th1 par déblocage de sa jonction bloquante entre le substrat 1 et la région 4.

Quand la borne A2 est positive par rapport à la borne A1, c'est le thyristor Th2 qui est susceptible d'être passant. Le schéma équivalent est alors celui de la figure 1C. Si l'on applique à la borne G une tension positive par rapport à l'électrode de face inférieure A1, par exemple une tension de l'ordre de 6 volts, un courant circule entre les bornes G et A1 en passant par la jonction base-émetteur du transistor T1. Ce transistor est rendu passant et un courant circule de la borne A2 par l'intermédiaire de la jonction anode/gâchette d'anode du thyristor Th2 puis à travers le transistor T1 vers la borne A1. Dans ce cas, le transistor T1 fonctionne normalement et le courant de gâchette d'anode est sensiblement égal au courant de base injecté multiplié par le gain du transistor.

On a donc bien obtenu une structure de triac dans lequel l'électrode de commande G est disposée sur la face avant mais dans lequel le triac est déclenché par application sur cette borne G d'une tension de polarité donnée (positive) par rapport à la tension sur l'électrode de la face arrière (A1).

La figure 2A représente une vue en coupe schématique d'un deuxième mode de réalisation de la présente invention. La structure des diverses zones formées dans le substrat semiconducteur est identique à celle illustrée en figure 1A. La différence entre les deux figures est que la région 11 est reliée à une métallisation M5 connectée à la gâchette G et que le caisson 10 est relié par une métallisation M6 à la diffusion profonde périphérique 7.

Ainsi, on a formé un transistor T2 de type NPN dont l'émetteur correspond à la région 11 et est connecté par la métallisation M5 à la gâchette G, dont la base correspond au caisson 10 et est reliée par la métallisation M6 et la diffusion profonde 7 à la borne A1, et dont le collecteur correspond au substrat 1, c'est-à-dire aux gâchettes d'anode des thyristors Th1 et Th2.

Le fonctionnement de ce deuxième mode de réalisation de la présente invention va être décrit en relation avec les figures 2B et 2C qui représentent des schémas équivalents dans le cas où la borne A2 est négative par rapport à la borne A1, par exemple à la masse, et dans le cas où la borne A2 est positive par rapport à la borne A1, respectivement.

Comme le montre la figure 2B, si, tandis que la borne A2 est négative par rapport à la borne A1, une tension négative est appliquée sur la gâchette, la jonction base-émetteur du transistor T2 est rendue passante et provoque la mise en conduction de ce transistor. Il en résulte qu'un courant circule de la borne A1 vers la jonction anode/gâchette d'anode du thyristor Th1 et, par le transistor T2, vers la borne de gâchette G. Le transistor T2 fonctionne normalement en amplificateur.

De même, dans le cas de la figure 2C où la borne A2 est positive par rapport à la borne A1, l'application d'une tension négative sur la borne G rend passant le transistor T2 par circulation d'un courant base-émetteur et ensuite un courant circule de la borne A2 vers la jonction anode/gâchette d'anode du thyristor Th2 puis à travers le transistor T2 vers la borne G. Le transistor T2 fonctionne aussi normalement en amplificateur.

En pratique, on préfère ce deuxième mode de réalisation de l'invention où, dans les deux cas, le transistor T2 fonctionne en amplificateur et où donc la commande est plus sensible. Cela a été constaté expérimentalement par l'inventeur.

Comme on l'a indiqué précédemment, le but de la présente invention n'est pas de prévoir un nouveau type particulier de triac à amplification de courant de gâchette mais de réaliser des triacs assemblables en un réseau de triacs dont chacun est connecté aux autres par sa face opposée à celle sur laquelle est formée la métallisation de gâchette. C'est bien ce que l'on obtient selon la présente invention.

On pourra assembler plusieurs triacs élémentaires tels que celui de la figure 1A ou 2A par brasure de leurs métallisations M1 sur un même radiateur relié à la masse ou, de préférence, on réalisera de façon monolithique dans un même substrat semiconducteur plusieurs triacs tels que celui de la figure 1A ou 2A.

Les figures 3A et 3B représentent un exemple de vue de dessus d'un réseau de triacs dont chacun correspond au triac de la figure 2A, assemblés selon la présente invention. La figure 3A est une vue de dessus avant réalisation de métallisations et la figure 3B est une vue de dessus illustrant les métallisations. Dans les figures 3A et 3B, quatre triacs TR1, TR2, TR3 et TR4 sont assemblés côte à côte dans un même substrat. Dans ces figures, on a désigné de mêmes éléments que ceux de la figure 2A par les mêmes références numériques.

On notera que les régions 3, 4 et 5 ont des formes allongées et parallèles. Un anneau 20 de type N⁺ est de façon classique formé à la périphérie des caissons P 4 et 5 pour servir d'arrêt de canal et est recouvert d'une métallisation M7. Cette métallisation M7 constitue une plaque d'équipotentielle fixant les champs en surface.

Tous les types de conductivité pourraient être inversés, les polarisations étant modifiées de façon correspondante. Les divers perfectionnements habituellement apportés aux structures des thyristors individuels d'un triac pourront être effectués, par exemple la prévision de zones de court-circuit d'émetteur.

On notera également que, de préférence, la région 6 de cathode du thyristor Th2 s'étend latéralement au-delà de la projection de la région 5 pour éviter une désensibilisation de ce thyristor.

## Revendications

1. Réseau de triacs dans lequel chaque triac comprend :
un substrat semiconducteur (1) du premier type de conductivité ayant une face avant et une face arrière,
une couche (2) du deuxième type de conductivité du côté de la face arrière,
une diffusion profonde (7) du deuxième type de conductivité reliant ladite couche (2) à la face avant,
un premier caisson (4) du deuxième type de conductivité contenant une première région (3) du premier type de conductivité, du côté de la face avant,
un deuxième caisson (5) du deuxième type de conductivité du côté de la face avant,
une deuxième région (6) du premier type de conductivité, du côté de la face arrière, sensiblement en regard du deuxième caisson,
un troisième caisson (10) du deuxième type de conductivité contenant une troisième région (11) du premier type de conductivité, du côté de la face avant,
une première métallisation (M1) du côté de la face arrière correspondant à une première électrode principale (A1),
une deuxième métallisation (M2) du côté de la face avant recouvrant la surface supérieure de la première région (3) et du deuxième caisson (5) et correspondant à une deuxième électrode principale (A2),
une troisième métallisation (M3 ; M5) recouvrant l'un du troisième caisson et de la troisième région et connectée à une borne de gâchette (G), et
une quatrième métallisation (M4 ; M6) reliant l'autre du troisième caisson et de la troisième région à la surface supérieure de ladite diffusion profonde (7).

2. Réseau de triacs selon la revendication 1, **caractérisé en ce que** tous les triacs sont formés dans un même substrat semiconducteur et **en ce que** la première métallisation est une métallisation commune recouvrant la face arrière.

3. Réseau de triacs selon la revendication 1 ou 2, **caractérisé en ce que** la diffusion profonde s'étend à la périphérie de chaque structure de triac.

4. Réseau de triacs selon l'une quelconque des revendications 1 à 3, dans lequel le premier type de conductivité est le type N.

5. Réseau de triacs selon l'une quelconque des revendications 1 à 4, dans lequel la borne de commande est reliée à la troisième région, **caractérisé en ce qu'**il comprend en outre des moyens pour appliquer à cette borne de commande une tension positive par rapport au potentiel de la première électrode principale.

6. Réseau de triacs selon l'une quelconque des revendications 1 à 4, dans lequel la borne de commande est reliée au troisième caisson, **caractérisé en ce qu'**il comprend en outre des moyens pour appliquer à cette borne de commande une tension négative par rapport au potentiel de la première électrode principale.

## Patentansprüche

1. Triac-Netzwerk, in welchem jeweils jedes Triac umfaßt:
- ein Halbleitersubstrat (1) vom ersten Leitfähigkeitstyp, mit einer Vorder- und einer Rückseite,
- eine Schicht (2) vom zweiten Leitfähigkeitstyp an der Rückseite,
- eine tiefe Diffusion (7) vom zweiten Leitfähigkeitstyp, welche die genannte Schicht (2) mit der Vorderseite verbindet,
- einen ersten Graben (4) vom zweiten Leitfähigkeitstyp, welcher einen ersten Bereich (3) vom ersten Leitfähigkeitstyp enthält, an der Vorderseite,
- einen zweiten Graben (5) vom zweiten Leitfähigkeitstyp, an der Vorderseite,
- einen zweiten Bereich (6) vom ersten Leitfähigkeitstyp, an der Rückseite, der im wesentlichen mit dem zweiten Graben ausgerichtet ist,
- einen dritten Graben (10) vom zweiten Leitfahigkeitstyp, welcher einen dritten Bereich (11) vom ersten Leitfähigkeitstyp enthält, an der Vorderseite,
- eine erste Metallisierung (M1) an der Rückseite, welche einer ersten Hauptelektrode (A1) entspricht,
- eine zweite Metallisierung (M2) an der Vorderseite, welche die Oberseite des ersten Bereichs (3) und des zweiten Grabens (5) bedeckt und einer zweiten Hauptelektrode (A2) entspricht,
- eine dritte Metallisierung (M3; M5), welche von den beiden Bereichen dritter Graben und dritter Bereich einen überdeckt und mit einem Gate-Anschluß (G) verbunden ist, sowie
- eine vierte Metallisierung (M4; M6), welche von den beiden Bereichen dritter Graben und dritter Bereich den jeweils anderen mit der Oberseite der genannten tiefen Diffusion (7) verbindet.

2. Triac-Netzwerk nach Anspruch 1,
**dadurch gekennzeichnet, daß** sämtliche Triacs in ein und demselben Halbleitersubstrat ausgebildet sind und daß die erste Metallisierung eine die Rückseite bedeckende gemeinsame Metallisierung ist.

3. Triac-Netzwerk nach Anspruch 1 oder 2,
**dadurch gekennzeichnet, daß** die tiefe Diffusion sich entlang dem Umfang jeweils jeder Triac-Struktur erstreckt.

4. Triac-Netzwerk nach einem der Ansprüche 1 bis 3,
in welchem der erste Leitfähigkeitstyp der N-Typ ist.

5. Triac-Netzwerk nach einem der Ansprüche 1 bis 4,
in welchem die Steuerelektrode mit dem dritten Bereich verbunden ist,
**dadurch gekennzeichnet, daß** das Netzwerk des weiteren Mittel zum Anlegen einer bezüglich dem Potential der ersten Hauptelektrode positiven Spannung an diesen Steueranschluß umfaßt.

6. Triac-Netzwerk nach einem der Ansprüche 1 bis 4, in welchem der Steueranschluß mit dem dritten Graben verbunden ist,
**dadurch gekennzeichnet, daß** das Netzwerk des weiteren Mittel zum Anlegen einer bezüglich dem Potential der ersten Hauptelektrode negativen Spannung an diesen Steueranschluß umfaßt.

## Claims

1. A triac network wherein each triac includes:
a semiconductor substrate (1) of the first type of conductivity having a front surface and a rear surface,
a layer (2) of the second type of conductivity on the rear surface side,
a deep diffusion (7) of the second type of conductivity connecting the layer (2) to the front surface,
a first well (4) of the second type of conductivity containing a first region (3) of the first type of conductivity, on the front surface side,
a second well (5) of the second type of conductivity on the front surface side,
a second region (6) of the first type of conductivity, on the rear surface side, substantially facing the second well,
a third well (10) of the second type of conductivity containing a third region (11) of the first type of conductivity, on the front surface side,
a first metallization (M1) on the rear surface side corresponding to a first main electrode (A1),
a second metallization (M2) on the front surface side covering the upper surface of the first region (3) and of the second well (5) and corresponding to a second main electrode (A2),
a third metallization (M3; M5) covering one of the third well and of the third region and connected to a gate terminal (G), and
a fourth metallization (M4; M6) connecting the other of the third well and of the third region to the upper surface of the deep diffusion (7).

2. A triac network according to claim 1, **characterized in that** all triacs are formed in a same semiconductor substrate and wherein the first metallization is a common metallization covering the rear surface.

3. A triac network according to claim 1 or 2, **characterized in that** the deep diffusion extends at the circumference of each triac structure.

4. A triac network according to any of claims 1 to 3, wherein the first type of conductivity is type N.

5. A triac network according to any of claims 1 to 4, wherein the control terminal is connected to the third region, and **characterized in that** it further includes means for applying to this control terminal a positive voltage with respect to the potential of the first main electrode.

6. A triac network according to any of claims 1 to 4, wherein the control terminal is connected to the third well, and **characterized in that** it further includes means for applying to this control terminal a negative voltage with respect to the potential of the first main electrode.
